# EUROPEAN PATENT APPLICATION

(11) **EP 3 324 454 A1**
(43) Date of publication of application: **23.05.2018**
(21) Application number: 16199702.8
(22) Date of filing: 18.11.2016
(51) Int. Cl.: H01L 35/32

(54) **THERMOELECTRIC ELEMENT**

(71) Applicant: European Thermodynamics Limited, Kibworth, Leicester LE8 0RX (GB)
(72) Inventor: TULEY, Richard, Leicester, Leicestershire LE8 0RX (GB); STUTTLE, Christopher, Leicester, Leicestershire LE8 0RX (GB); SIMPSON, Kevin, Leicester, Leicestershire LE8 0RX (GB)
(74) Representative: Barker Brettell LLP

(57) **Abstract**

A thermoelectric element comprising: a body comprising, or consisting essentially of, a thermoelectric material, the body having: a first heat transfer face and a second heat transfer face, wherein the first heat transfer face and the second heat transfer faces are opposing planar faces; two or more principal lateral faces, each principal lateral face extending between the first heat transfer face and the second heat transfer face; and at least one joining lateral face, the or each joining lateral face being bounded by an edge of each of a pair of principal lateral faces and an edge of at least one of the first and second heat transfer faces; wherein the or each joining lateral face is not co-planar with either of said pair of principal lateral faces.

## Description

### Technical Field

This invention relates to thermoelectric elements, thermoelectric modules and thermoelectric devices such as thermoelectric generators and thermoelectric coolers. This invention also relates to methods of manufacture and uses of thermoelectric elements, thermoelectric modules and thermoelectric devices.

### Background to the Invention

Waste heat recovery using thermoelectric generators can improve energy efficiency and provide electrical power in hard-to-reach locations where mains power cannot reach. Applications include, but are not limited to, automotive, aerospace and power plants. In addition, thermoelectric cooling can provide an environmentally "green" method of cooling on a small scale suitable for example for electronic and optoelectronic applications. There is an ever-increasing demand for greater power conversion efficiency, stimulating the research of novel thermoelectric materials and device concepts.

Thermoelectric power generation is driven by the Seebeck effect, a phenomenon that occurs in most electrical conductors, to a greater or lesser extent, describing the conversion of a temperature gradient within the conductor to a voltage. When two ends of a conductor (the thermoelectric material) are held at different temperatures, the magnitude of the thermal voltage (Vₜₕ) developed across the conductor is proportional to the temperature difference (AT) through the relationship Vₜₕ = SΔT, where S is the Seebeck coefficient or thermopower. When the two ends of the thermoelectric material are electrically connected to form a closed circuit, a thermal current flows according to Iₜₕ=Vₜₕ/R, where R is the resistance of the thermoelectric material. To maximise the efficiency of thermoelectric power generation, thermoelectric materials must have a large Seebeck coefficient to generate large thermal voltages, a low thermal conductance to help maintain the temperature difference, and high electrical conductivity to minimise power dissipation within the thermoelectric material.

The Seebeck coefficient is an intrinsic property of a material: it is typically very low for metals (a few μV/K) and much larger in semiconductors (a few hundred μV/K). In addition, metals typically have very high thermal conductivity. As a result, semiconductors are almost exclusively used as thermoelectric materials in thermoelectric modules and thermoelectric devices, e.g. thermoelectric generators and thermoelectric coolers.

Running in parallel with thermoelectric materials research is a drive to optimise the design of thermoelectric modules and/or thermoelectric devices to improve reliability and lifetime. A thermoelectric module typically comprises an array of thermoelectric elements (comprising a thermoelectric material) connected electrically in series via metallic interconnects, and thermally in parallel between two ceramic substrates, which constitute, in use, a hot and a cold side of the module. In many heat-recovery applications, the thermoelectric modules are subjected to large temperature gradients as well as rapid and frequent thermal cycling. Due to the presence of differing materials from one side of the module to the other, the large thermal gradient across the thermoelectric elements can cause mechanical tensile and compressive stresses to occur within the elements. These thermally-induced stresses contribute to reduced efficiency, reliability and lifetime of the thermoelectric module, due to the generation of mechanical fractures or cracks. Micro-fractures or cracks increase the module resistance and reduce power output. Eventually, crack propagation leads to complete fracture of the element. Furthermore, failure of a single element causes failure of the entire module, because the thermoelectric elements are electrically connected in series. This problem may be accentuated in modern heat conversion systems comprising several thermoelectric modules connected in series.

There is therefore a need for thermoelectric modules that offer improved reliability and lifetime, preferably without sacrificing power output and/or efficiency.

### Summary of the Invention

According to a first aspect of the invention, there is provided a thermoelectric element comprising a body comprising, or consisting essentially of, a thermoelectric material, the body having: a first heat transfer face and a second heat transfer face, wherein the first heat transfer face and the second heat transfer face are opposing planar faces; two or more principal lateral faces, each principal lateral face extending between the first heat transfer face and the second heat transfer face; and at least one joining lateral face, the or each joining lateral face being bounded by an edge of each of a pair of principal lateral faces and an edge of at least one of the first and second heat transfer faces, wherein the or each joining lateral face is not co-planar with either of said pair of principal lateral faces.

Advantageously, the presence of the joining lateral face(s) may reduce the number of sharp edges or corners in the thermoelectric element. Consequently, in use, thermally-induced stresses within the thermoelectric element may be reduced, which may help to improve the reliability and/or lifetime of the thermoelectric element.

The body may be described as a solid body or a polyhedron body.

In use, the first heat transfer face and the second heat transfer face may be held at different temperatures and a thermoelectric voltage may be generated therebetween.

In an embodiment, the surface area of one or more of the, or each, joining lateral faces may be smaller than the surface area of at least one of, or optionally both of, the adjoining principal lateral faces.

In embodiments, the or each joining face may be bounded by an edge of both of the first and second heat transfer faces.

In embodiments, at least one of the or each joining faces may be a convexly curved joining face. The, or each, convexly curved joining face may have a uniform radius of curvature. Alternatively, the, or each, curved joining face may have a non-uniform radius of curvature. The, or each, curved joining face may be curved in at least one dimension, e.g. in one or two dimensions.

In an embodiment, the two or more principal lateral faces may be substantially perpendicular to the first and second heat transfer faces. Alternatively, the two or more principal lateral faces may not be substantially perpendicular to the first and second heat transfer faces.

In an embodiment, the thermoelectric element may comprise three, four, five, six, seven or eight principal lateral faces. In an embodiment with four principal lateral faces, the four principal lateral faces may for example be substantially perpendicular to the first and second heat transfer faces.

In an embodiment, the thermoelectric element may comprise any number of joining faces, e.g. from one joining face and/or up to twice the number of principal lateral faces. Thus, for example, the thermoelectric element may comprise one, two, three, four, five, six, seven, eight, nine, 10, 11, 12, 13, 14, 15 or 16 joining faces. The number of joining faces may be the same as the number of principal lateral faces.

The area lost on the first heat transfer face and/or the second heat transfer face due to the introduction of the joining lateral face(s) may be at least 1% and/or up to 20%.

Suitable thermoelectric materials may include, but are not limited to: bismuth telluride; bismuth selenide; antimony telluride; lead telluride; lead selenide; magnesium silicide; magnesium stannide; higher manganese silicide; skutterudite materials; Half Heusler alloys; silicon-germanium, and combinations of the above. Suitable thermoelectric materials may also include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

According to a second aspect of the invention, there is provided a thermoelectric module comprising one or more thermoelectric elements according to the first aspect of the invention.

According to a third aspect of the invention, there is provided a device comprising at least one thermoelectric module according to the second aspect of the invention. The device may be a thermoelectric generator, or a thermoelectric cooler.

According to another aspect of the invention, there is provided a use of a thermoelectric module according to the second aspect of the invention or a thermoelectric device according to the third aspect of the invention to generate electrical power or to provide cooling.

Features of the aspects and embodiments described above and below may be used interchangeably and/or in combination, even if not expressly stated.

### Brief Description of Drawings

In order that the invention can be well understood, embodiments will now be discussed by way of example only with reference to the accompanying drawings, in which:
Figure 1 is an illustration of an arrangement of thermoelectric elements within a thermoelectric module;
Figure 2 is a side view of the thermoelectric elements shown in Figure 1.
Figure 3 is an illustration of a thermoelectric module;
Figure 4 is a side view of the thermoelectric module shown in Figure 3.
Figure 5 is a schematic plan view of a thermoelectric element of the type shown in Figure 1;
Figure 6 is a schematic perspective view of the thermoelectric element of Figure 5;
Figure 7 is a contour map showing the distribution of modelled raw stresses in the cross-section shown in Figure 6 resulting from a thermal gradient from top to bottom for a thermoelectric element from the corner of a module;
Figure 8 is a schematic plan view of an example chamfered thermoelectric element according to the invention;
Figure 9 is a schematic perspective view of the thermoelectric element shown in Figure 8;
Figure 10 is a schematic illustration of an array of thermoelectric elements of the type shown in Figure 8 suitable for use in a thermoelectric module according to the invention;
Figure 11 is a schematic plan view of another example embodiment of a thermoelectric element according to the invention, the thermoelectric element having curved edges;
Figure 12 is a schematic perspective view of an the thermoelectric element shown in Figure 11;
Figure 13 is a schematic illustration of an array of thermoelectric elements of the type shown in Figure 11 suitable for use in a thermoelectric module according to the invention;
Figure 14 shows the reduction in maximum thermally-induced raw stress at the upper boundary of a thermoelectric element according to the invention as a function of the extent of the curved and chamfered section normalised to the width of the thermoelectric element, obtained from numerical modelling;
Figure 15 shows the reduction in maximum thermally-induced raw stress at the upper boundary of a thermoelectric element according to the invention as a function of the area loss at the corners relative to a thermoelectric element with a square cross section, obtained from numerical modelling.
Figure 16 shows the reduction in maximum thermally-induced raw stress at the upper boundary of a thermoelectric element according to the invention as a function of the area loss at the corners due to a curved section relative to a thermoelectric element with a square cross section, obtained from numerical modelling for a number of different geometries.

### Detailed Description

The polarity of the thermal voltage generated in a thermoelectric material is dependent on the charge carrier type. Semiconductors can exhibit either electron (n-type) conduction with a negative thermopower or hole (p-type) conduction with a positive thermopower by the introduction of extrinsic dopants to the semiconductor crystal. Therefore, by connecting an n-type and a p-type semiconductor electrically in series and thermally in parallel, the thermal voltage across each element adds. This principle is applied in thermoelectric modules comprising many such n-type and p-type thermoelectric elements to increase the thermoelectric power generation.

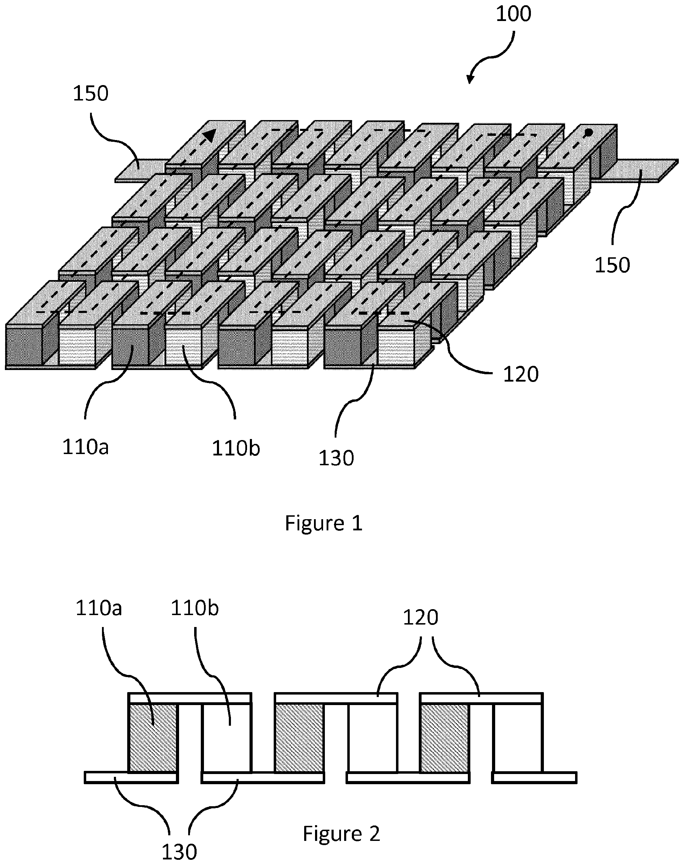

Figure 1 illustrates a typical arrangement of thermoelectric elements in a thermoelectric module 100 known in the art. In this example, the module 100 comprises thirty two n-type 110a and thirty two p-type 110b thermoelectric elements (also known as pellets) arranged side by side in an 8x8 array. Each element 110a, 110b is associated with an upper metallic contact 120 and a lower metallic contact 130. Each n-type element 110a is electrically connected to an adjacent p-type element 110b to form a series circuit of alternating n-type 110a and p-type 110b elements as illustrated in Figure 1 by the dashed arrow. An electrical lead 150 is provided at the beginning and end of the series circuit for connecting the module 100 to an external load.

Figure 2 shows a schematic side view of the module 100 illustrating the connection of adjacent elements 110a, 110b in the series circuit. In this example, n-type elements 110a and p-type elements 110b are the same size and shape as each other. However, elements 110a, 110b may for example have different cross-sectional areas depending on the material properties of the n-type elements 110a and the p-type elements 110b. For example, if the conductivity of the n-type and p-type materials differs substantially, the cross-sectional areas of the elements 110a, 110b may be chosen such that their resistances match.

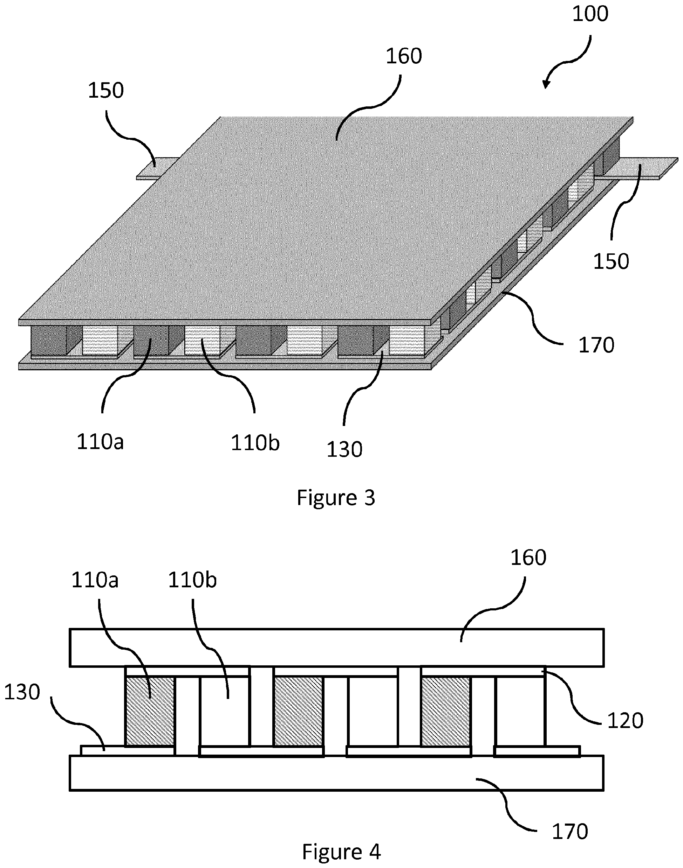

Figure 3 shows the assembled thermoelectric module 100. The thermoelectric elements shown in Figure 1 are mounted between an upper ceramic substrate 160 and a lower ceramic substrate 170.

Figure 4 shows a corresponding side view of the assembled thermoelectric module 100. The ceramic substrates 160, 170 hold the overall module 100 together mechanically, and electrically insulate the elements 110a, 110b and metallic contacts 120, 130 from external mounting surfaces. In use, for example, ceramic substrate 160 may be placed in thermal contact with a hot mounting surface, while the substrate 170 is held at a substantially lower temperature. Heat from the hot surface is transferred through the ceramic substrate 160 to the thermoelectric elements 110a, 110b generating a (nominally identical) thermal gradient across all elements 110a, 110b in the module 100. The thermoelectric elements 110a, 110b are therefore thermally connected to the heat source in parallel. Ceramic substrates must be mechanically strong and have a high thermal conductivity. An example of a suitable material used for the ceramic substrate is aluminium oxide or aluminium nitride.

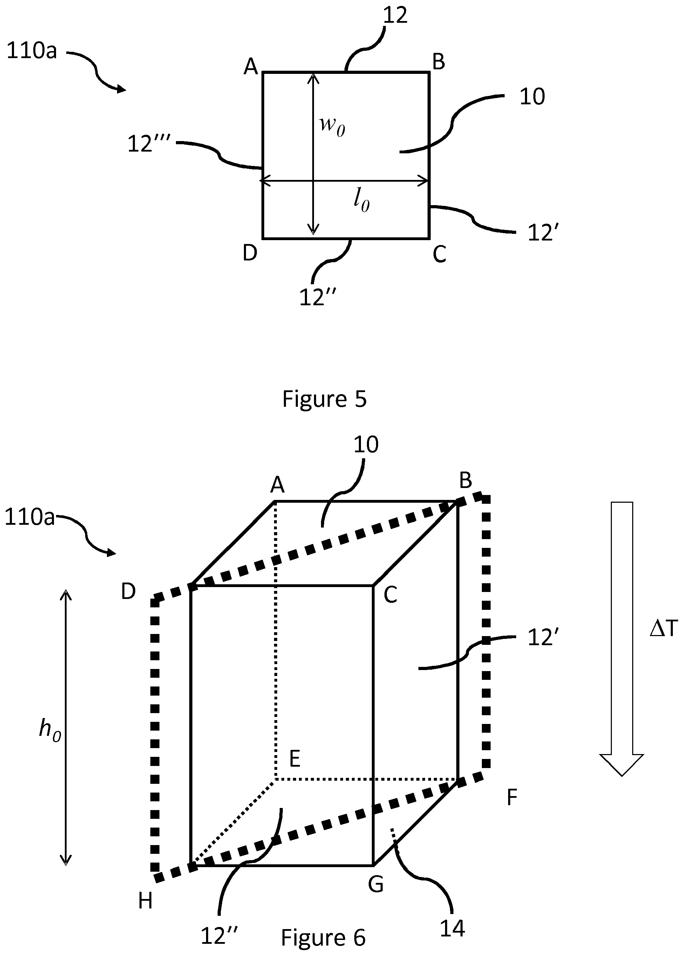

Figure 5 shows a schematic plan view of an n-type thermoelectric element 110a of the type shown in Figure 1 to 4. As the n-type thermoelectric elements 110a and p-type thermoelectric elements 110b shown in Figures 1 to 4 are geometrically identical, only one will be described in detail here. Thermoelectric element 110a has a square top face 10 and four identical lateral faces 12, 12', 12", 12"'. The top face 10 has a cross-sectional area A₀. The length *l*₀ and width *w*₀ of the element 110a are the same. The four corners of the top face 10 are labelled A, B, C and D.

Figure 6 shows a perspective view of the thermoelectric element 110a of Figure 5. The thermoelectric element 110a is a cuboid with four identical rectangular lateral faces 12, 12', 12", 12'" defining the height *h₀* and the pellet 110a and extending between the top face 10 and a bottom face 14. The top face 10 and a bottom face 14 are identical, and, in use, provide a pair of opposing planar heat transfer faces. The four corners of the bottom face 14 are labelled E, F, G and H. Corners E, F, G and H are located below corners A, B, C and D respectively.

In use, a thermoelectric module 100 is typically clamped to a mounting surface (a hot surface) to ensure good thermal contact with a heat source. The other side of the thermoelectric module 100 (the cold side) may be in thermal contact with a heat exchanger. The mounting surface is typically a metal such as copper, aluminium or steel. As the mounting surface heats up, a temperature gradient across the module 100 is established and is converted to electrical power.

The thermal gradient across the thermoelectric module 100 causes mechanical tensile and compressive stresses to occur within the elements 110a, 110b, due to the range of differing materials (with different material properties) and interfaces from one side of the thermoelectric module 100 to the other. These thermally-induced stresses can lead to micro cracks forming within the elements 110a, 110b, which increase the resistance of the elements 110a, 110b and reduce the power output of the module 100. Eventually, crack propagation may lead to complete failure of one or more of the thermoelectric elements 110a, 110b. As the thermoelectric elements 110a, 110b are connected in series, failure of only one thermoelectric element 110a, 110b leads to failure of the module 100. Thermal stresses therefore can contribute to reduced efficiency, reliability and/or lifetime of the module 100.

This may be particularly relevant in automotive applications where the thermal environment is relatively extreme and where frequent and rapid thermal cycling is commonplace. The variable operating conditions, for example, starting the vehicle up from cold, accelerating to high speed, stop-start moving in traffic and steady travelling on the motorway, means that the temperature of the heat source (e.g. an exhaust or radiator) and the frequency of the thermal cycling are unpredictable. These variable operating conditions place a significant demand on the reliability and lifetime of a given component, which the component must meet in order for it to be incorporated in a vehicle.

To elucidate the main effects of a thermal load on the stresses within a thermoelectric element 110a we have modelled the thermally-induced raw stresses in a thermoelectric module 100 using a simplified finite element analysis model implemented in COMSOL Multiphysics. The details of the model and assumptions made are discussed below.

When heated up, the mounting surface of the heat source and the module 100 undergo thermal expansion (in all directions). Meanwhile, because the clamping mechanism stays relatively cold, vertical expansion of the module 100 is to a certain extent suppressed. In addition, because the module 100 is clamped to, and the ceramic substrate is frictionally engaged with, the hot mounting surface, the lateral expansion of the module relative to the hot surface will also be affected. As such, an installed thermoelectric module 100 is a complex thermal and mechanical system to model.

To simplify the model, the following boundary conditions were used in the model: (i) the temperature of the upper ceramic 160 was fixed at 250°C and the temperature of the bottom ceramic 170 was fixed at 30°C; (ii) zero net vertical displacement of the module 100 (ideal clamping); (iii) no slipping of the ceramic so that lateral expansion of the upper face of the (hot) ceramic 160 is matched to that of steel at the same temperature; (iv) zero lateral expansion of the lower face of the (cold) ceramic 170.

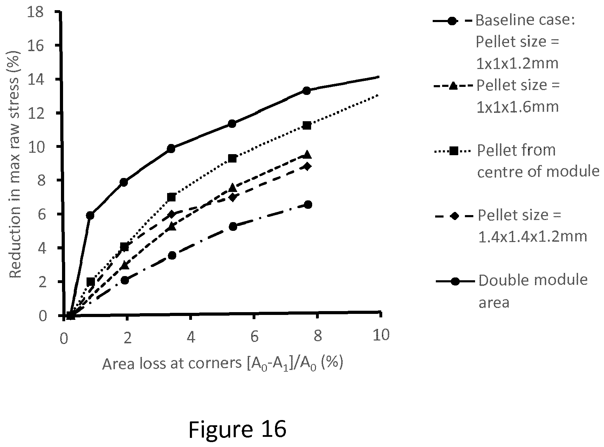

In addition, in the numerical calculations we have assumed that the thermoelectric material is a linear isotropic material with no difference in the tensile or compressive strain modulus, and that there are no built-in stresses that may result from the manufacture of a thermoelectric module 100. The dimensions of the element 110a were chosen to be *l₀* = *w*₀ = 1 mm and *h =* 1.2 mm to represent an example module. Results for different geometries are numerically different, but show a similar pattern (see, for example, discussion of figure 16 below)

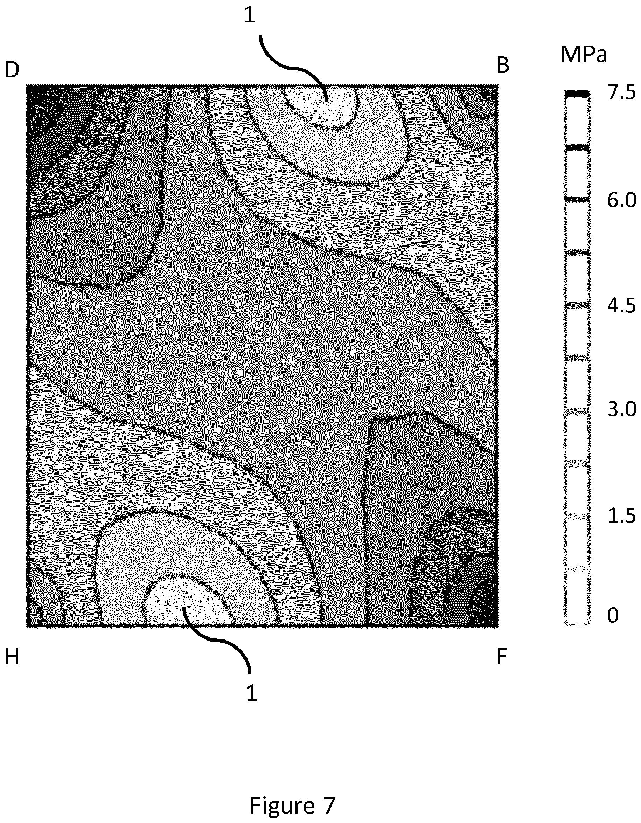

Figure 7 shows a contour plot of the modelled thermally-induced stresses in the cuboidal thermoelectric element 110a (or 110b) in the vertical plane DBHF (indicated by the dashed lines in Figure 6). The data is presented for a cross section through an element 110a (or 110b) from the corner of a module 100, as often the maximum stresses can occur in this position. The outermost edge of the element is indicated by the line BF. Data presented are averages taken over a radius of 0.01 mm to reduce artefacts due to meshing. The stress distribution is dependent on a number of factors, including but not limited to module size, element size and element position in the module. In most cases maximum stresses occur at the corners or edges of the module.

The thermal load produces a mixture of vertical and lateral stresses within the element 110a (or 110b). To simplify the analysis, these stresses are presented as Von Mises stresses, representing an effective magnitude of the overall thermally-induced stresses. As shown in Figure 7, thermally-induced stresses are largest in the corners of the element 110a (D, B, H, F) at the top face 10 and the bottom face 14. A minimum thermally-induced stress is found in the areas labelled 1 in Figure 7, which are located away from the corners of the element 110a in a generally central portion of each of the top face 10 and the bottom face 14..

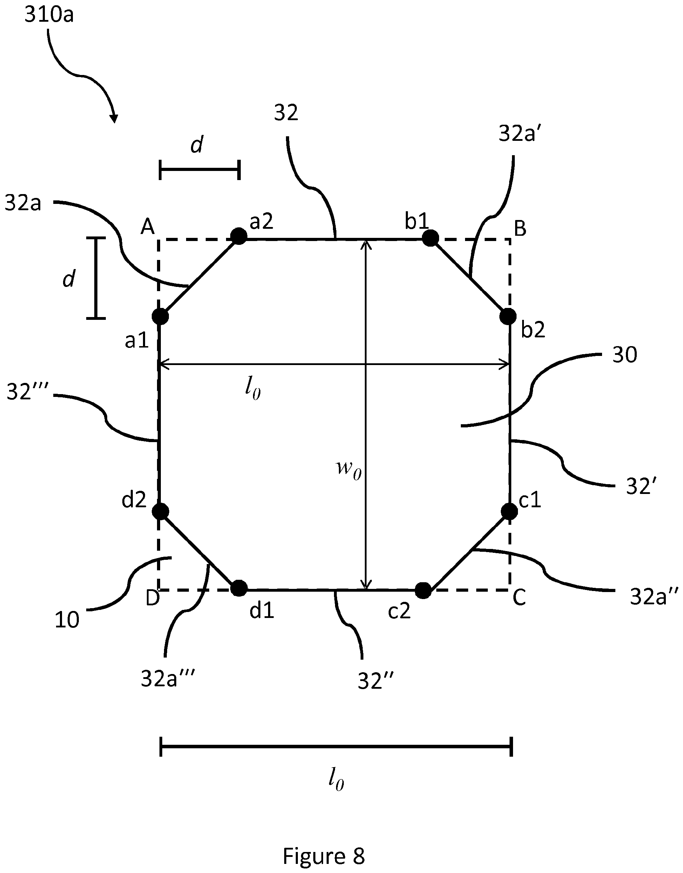

Figure 8 shows a plan view of an example of a thermoelectric pellet 310a according to an embodiment of the invention. The outline of the square top surface 10 of element 110a is shown by dashed lines for comparison (in this example, the length *l*₀ and width *w*₀ of element 310a is equal to the length *l*₀ and width *w*₀ of element 110a). Element 310 has a top face 30 bounded by four principal lateral faces 32, 32', 32", 32'" and four additional joining faces 32a, 32a', 32a", 32a"'. Each joining face 32a, 32a', 32a", 32a'" is between a pair of principal lateral faces. As is evident from Figure 8, the top face 30 of the thermoelectric element 310a is characterised generally by having chamfered or cut-away corners, such that each sharp square corner of element 110a, where thermally-induced stresses can be concentrated, in use, is replaced by a joining face 32a, 32a', 32a", 32a"'. Each joining face is not co-planar with either of the pair of adjacent principal faces. The top surface 30 of element 310a has an area A₁.

Points A, B, C and D in Figure 8 represent the locations of the effective corners of top surface 30 of pellet 310a, defined by the extrapolated points of intersection of the principal lateral faces 32, 32', 32", 32"'. As such, each joining face 32a, 32a', 32a", 32a'" is associated with an effective corner A, B, C, D respectively.

As shown in Figure 8, each joining face 32a, 32a', 32a", 32a'" has a start point and an end point located on adjacent principal lateral faces 32, 32', 32", 32'" at a predefined distance *d* from the effective corner (A, B, C, D). The predefined distance *d* from the effective corner is less than half of the width *l*₀, typically less than a third of the width *l*₀ or less than a quarter of the width *l*₀. At effective corner A the associated joining face 32a extends between point a1 (located on line DA at a distance *d* from corner A) and point a2 (located on line AB at a distance *d* from corner A). At effective corner B, the associated joining face 32a' extends from point b1 (located on side AB at a distance *d* from corner B) to point b2 (located on side BC at a distance *d* from corner B). At effective corner C, the associated joining face 32a" extends from point c1 (located on side BC at a distance *d* from corner C) to point c2 (located on side CD at a distance *d* from corner C). At effective corner D, the associated joining face 32a'" extends from point d1 (located on side CD at a distance *d* from corner D) to point d2 (located on side DA at a distance *d* from corner D).

The chamfer is defined by a straight line connecting the start and end points (for example, points a1 and b1 of corner A), such that the joining faces 32a, 32a', 32a", 32a'" are planar faces. In the embodiment shown in Figure 8, the predetermined distance *d* of each start and end points (a1; a2, b1; b2, c1; c2, d1; d2) from the associated corner (A, B, C, D) is the same, such that joining faces 32a, 32a', 32a", 32a'" of pellet 310a make a 45 degree chamfer. The extent of the chamfer may be defined by the ratio *d*/*l*₀. The ratio *d*/*l*₀ may vary in the range 0 < *d*/*l*₀ < 0.5. For example, the ratio *d*/*l₀* may be up to or at least 0.4, up to or at least 0.3, up to or at least 0.2, or up to or at least 0.1. In an embodiment, the ratio *d*/*l₀* may be approximately 0.25. The extent of the chamfer may also be characterised by the area loss at the corner relative to the cuboid element 110a of the same width given by (A₀-A₁)/A₀.

In other embodiments, the predetermined distance *d* of each start and end points (a1; a2, b1; b2, c1; c2, d1; d2) from the associated corner (A, B, C, D) may not be the same, such that pellet 310a may comprise joining faces 32a, 32a', 32a", 32a'" of any angle (greater than zero and less than 90 degrees). In other embodiments, the distance *d* of the start and end point of the chamfer associated with each corner may be different, such that pellet 310a may for example comprise a different chamfer at each corner.

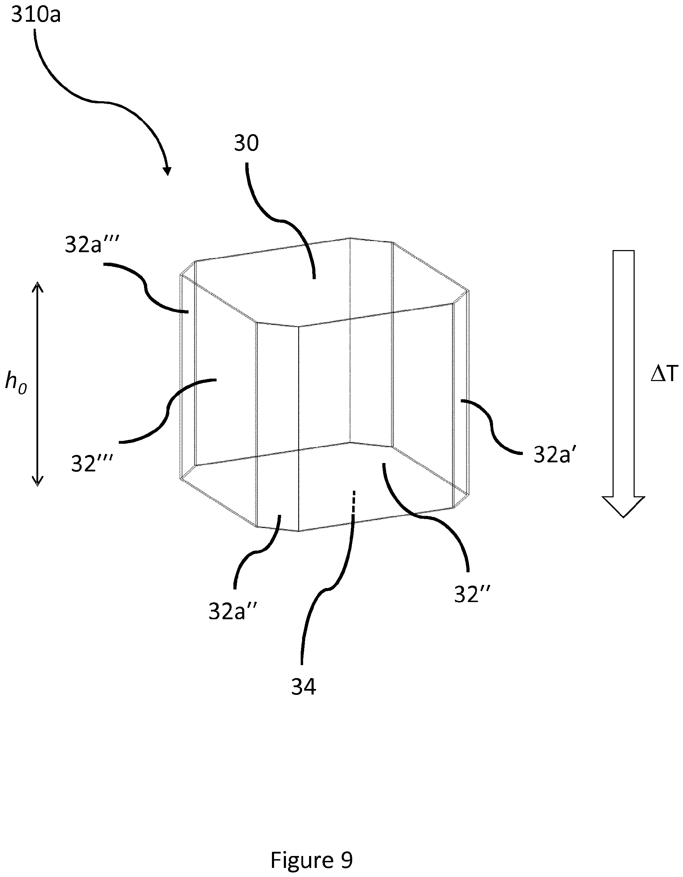

Figure 9 shows a perspective view of the thermoelectric element 310a. The thermoelectric element 310a has a top face 30 and a bottom face 34 that, in use, provide a pair of opposing (parallel) planar heat transfer faces. As such, the intended orientation of the thermoelectric element 310a, in use, is indicated by the direction of the temperature gradient, ΔT, as indicated in Figure 9. The top face 30 and the bottom face 34 may also be referred to as, respectively, the first heat transfer face 30 and the second heat transfer face 34.

Each principal lateral face 32, 32', 32", 32'" extends between the top face 30 and the bottom face 34. Each joining face 32a, 32a', 32a", 32a'" is bounded by a pair of adjacent principal lateral faces 32, 32', 32", 32'" and both the top face 30 and the bottom face 34. As such, the thermoelectric element 310a may generally be considered to comprise, or consist essentially of, a polyhedron body with the above-described features.

In other embodiments, each joining face 32a, 32a', 32a", 32a'" may be bounded by a pair of adjacent principal lateral faces 32, 32', 32", 32'" and only one of the top face 30 or the bottom face 34. In embodiments, the element 310a may comprise more or fewer than four joining faces 31a. For example, for an element 310a with *n* principal lateral faces, the number of joining faces may be chosen to be at least 1 and/or up to 2*n*.

In the example embodiment shown in Figure 9, the surface area of each joining face 32a, 32a', 32a", 32a'" is smaller than the surface area of each of the adjacent principal lateral faces 32, 32', 32", 32"'. In the embodiment shown in Figure 9 the surface area of each joining face 32a, 32a', 32a", 32a'" is the same; however, this is not essential. For example, in embodiments, the surface area of one or more of the joining faces 32a, 32a', 32a", 32a'" may be different from the others.

In the example embodiment shown in Figures 8 and 9, principal lateral faces 32, 32', 32", 32" are perpendicular to the top surface 30 and the bottom surface 34, i.e. they may be considered to be substantially vertical. However, this is not essential. For example, in other embodiments of an element with four principal lateral faces, the length *l*₀ and/or width *w*₀ of the top surface may be different from the length *l*₀ and/or width *w*₀ of the bottom surface, such that one or more of the principal lateral faces may not be perpendicular to the top surface 30 and the bottom surface 34.

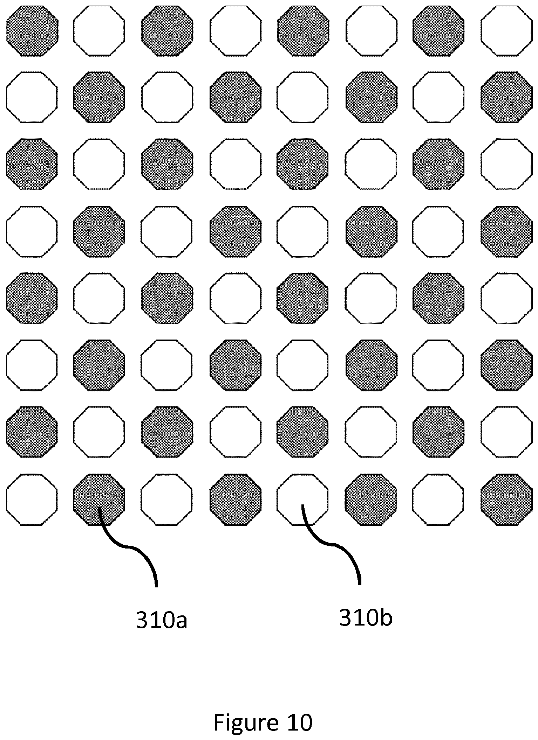

Figure 10 shows an 8 x 8 array of 32 n-type elements 310a and 32 p-type elements 310b suitable for use in a thermoelectric module according to the invention. The n-type thermoelectric elements 310a are of the type described above in relation to Figures 8 and 9. In this example embodiment, the p-type thermoelectric elements 310b are geometrically identical to the n-type thermoelectric elements 310a. The array is a square-based array.

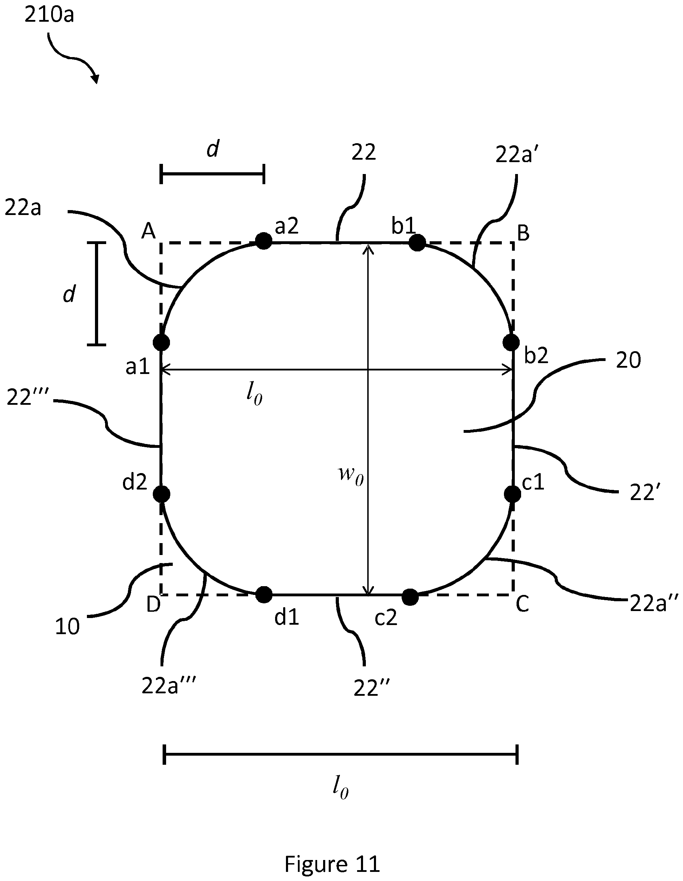

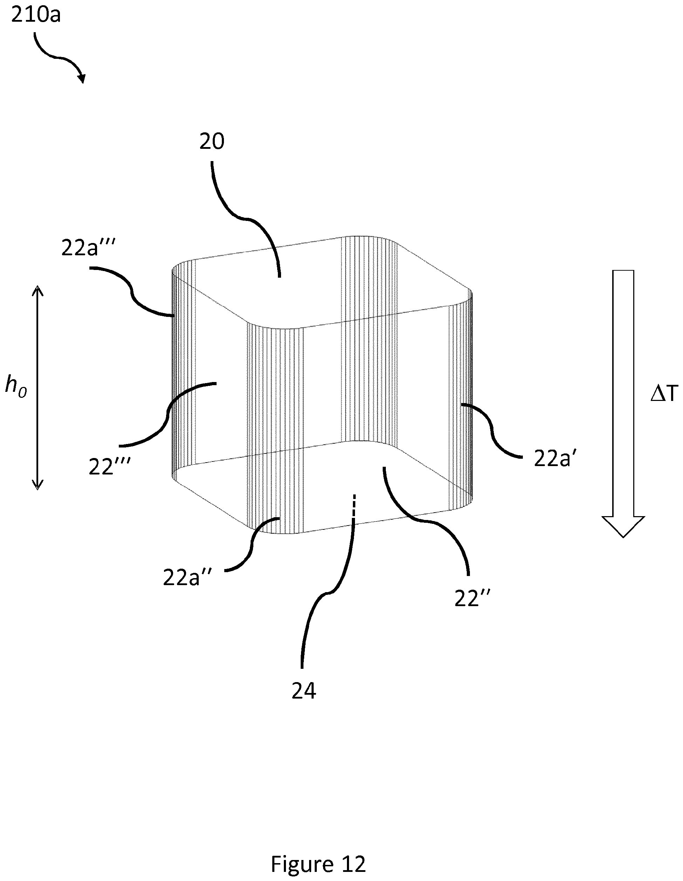

Figures 11 and 12 show, respectively, a plan view and perspective view of an example thermoelectric element 210a according to another embodiment of the invention. Thermoelectric element 210a has a top face 20 and a bottom face 24 that, in use, provide a pair of opposing (parallel) planar heat transfer faces.

The outline of the square top surface 10 of element 110a is shown by dashed lines for comparison (in this example, the length *l₀* and width *w₀* of thermoelectric element 210a are equal to the length *l₀* and width of thermoelectric element 110a). The thermoelectric element 210a has four principal lateral faces 22, 22', 22", 22'" and four convexly curved joining faces 22a, 22a', 22a", 22a"'. Each joining face is adjacent to (between) a pair of principal lateral sides. The thermoelectric element 210a can be characterised generally as having rounded or convexly curved corners, such that, by way of comparison, each sharp square corner of element 110a, where thermally-induced stresses are concentrated, in use, is replaced by a convexly curved joining face. Each joining face is not co-planar with either of the pair of adjacent principal faces. The top surface 20 of element 210a has an area A₁.

Points A, B, C and D in Figure 8 represent the locations of the effective corners of top surface 30 of pellet 310a, defined by the extrapolated points of intersection of the principal lateral faces 32, 32', 32", 32"'. As such, each joining face 32a, 32a', 32a", 32a'" is associated with an effective corner A, B, C, D respectively.

As shown in Figure 11, each joining face 22a, 22a', 22a", 22a'" has a start point and an end point located on adjacent principal lateral faces 22, 22', 22", 22'" at a predefined distance *d* from the effective corner (A, B, C, D). The predefined distance *d* from the effective corner is less than half of the width *l*₀, typically less than a third of the width *l*₀ or less than a quarter of the width *l*₀. At effective corner A the associated joining face 22a extends between point a1 (located on line DA at a distance *d* from corner A) and point a2 (located on line AB at a distance *d* from corner A). At effective corner B, the associated joining face 22a' extends from point b1 (located on side AB at a distance *d* from corner B) to point b2 (located on side BC at a distance *d* from corner B). At effective corner C, the associated joining face 22a" extends from point c1 (located on side BC at a distance *d* from corner C) to point c2 (located on side CD at a distance *d* from corner C). At effective corner D, the associated joining face 22a'" extends from point d1 (located on side CD at a distance *d* from corner D) to point d2 (located on side DA at a distance *d* from corner D).

In the example embodiment shown in Figures 11 and 12, the joining faces 22a, 22a', 22a", 22a'" are convexly curved with a constant or uniform radius of curvature , equal to the predetermined distance d. In other embodiments, the joining faces 22a, 22a', 22a", 22a'" may be convexly curved faces with a varying or non-uniform radius of curvature, such as an elliptical curvature, or any convex curve that deviates from a straight line connecting the start and end points (for example, points a1 and a2 of effective corner A).

In the example embodiment shown in Figures 11 and 12, the joining faces 22a, 22a', 22a", 22a'" join smoothly with the principal lateral faces 22, 22', 22", 22"'. However, this is not essential. In other embodiments, the joining faces 22a, 22a', 22a", 22a"' may not join smoothly with the principal lateral faces 22, 22', 22", 22'" such that the derivative of the perimeter line (or outline) of the element 210a may exhibit a discontinuity at the start and/or end points.

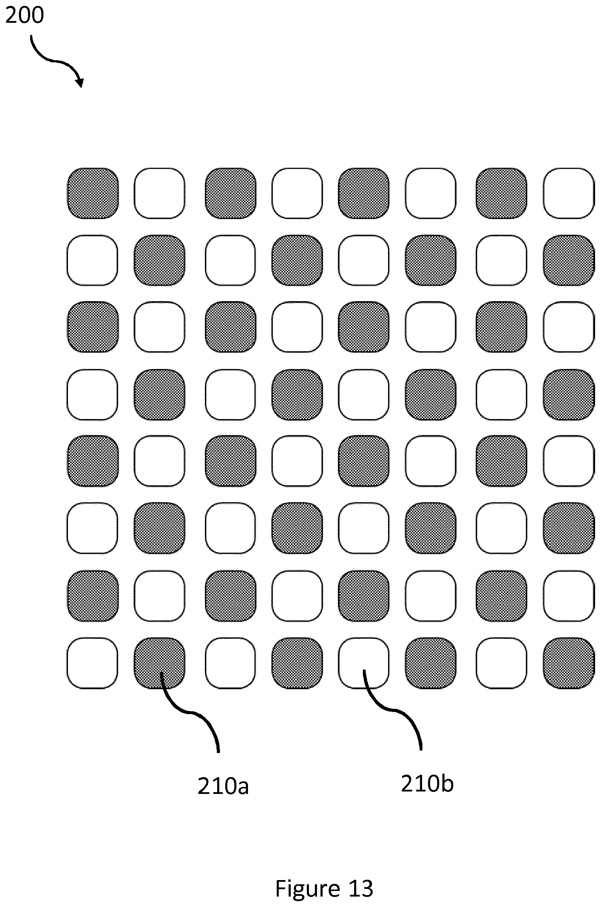

Figure 13 shows an 8 x 8 array of 32 n-type thermoelectric elements 210a and 32 p-type thermoelectric elements 210b suitable for use in a thermoelectric module according to the invention. The n-type thermoelectric elements 210a are of the type described above in relation to Figures 11 and 12. In this example embodiment, the p-type thermoelectric elements 210b are geometrically identical to the n-type thermoelectric elements 210a. The array is a square-based array.

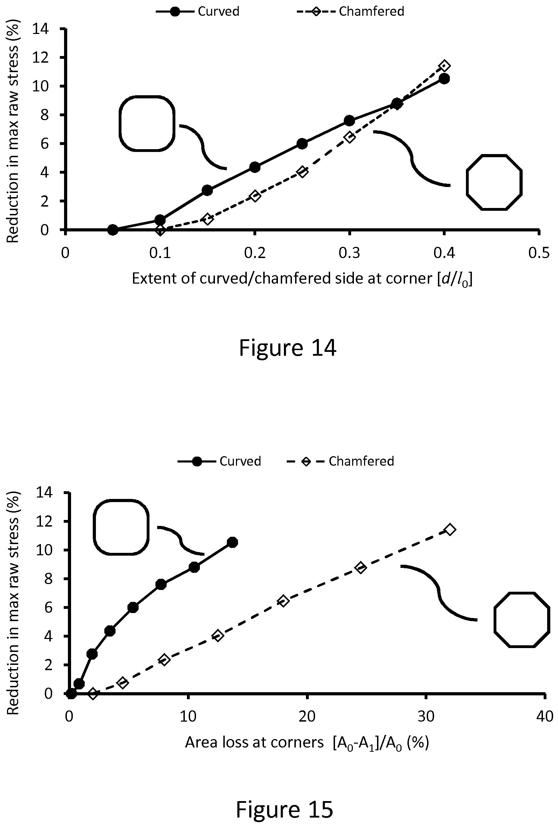

Numerical calculations of the thermally-induced von Mises stresses in thermoelectric elements 210a and 310a with joining faces of varying extent (*d*/*l*₀) were performed using the same model and conditions as used in Figure 7. The length, width and height of the modelled elements 210a and 310a is the same as that of element 110a used in Figure 7. The results are compared to the results obtained from element 110a and presented in Figures 14 and 15.

Figure 14 shows the calculated reduction in maximum raw stresses at the top surface 20 and top surface 30 of element 210a (closed symbols) and 310a (open symbols), respectively, as a function of the extent (*d*/*l*₀) of the joining faces. The reduction in maximum stress is relative to that in a square element 110a (d = 0). As shown by the open and closed symbols in Figure 14, the maximum thermally-induced stress within the elements 210a and 310a is substantially reduced compared with a square element 110a, and the reduction increased with increasing extent of the joining face (*d*/*l*₀).

A reduction of approximately 10-12 % in the maximum raw stresses in the top surfaces 20,30 of elements 210a and 310a was found for *d*/*l*₀ ∼ 0.4, that is, with joining faces extending to about 40% of the width of the element 210a, 310a.

Figure 15 shows the same data as in Figure 14 plotted as a function of the area loss at the corners (A₀-A₁)/A₀ relative to a square element 110a. This value represents the amount of thermoelectric material removed from the element 110a to produce the geometry of elements 210a and 310a. The amount of thermoelectric material removed has a direct negative influence on the output power of a thermoelectric module through the fill factor of the array (e.g. a square array) of elements in the thermoelectric module. The fill factor is the ratio of the amount of module surface occupied by thermoelectric elements to the overall surface area of the module (that is, the summed top surface area of every element in the module versus the upper surface area of the upper ceramic substrate). It represents the fraction of heat than can be transferred from the ceramic substrate to the thermoelectric elements in the module and used for power conversion. The greater the extent (*d*/*l*₀) of the chamfers or convexly curved joining face, the greater the area loss, and thus the greater the loss in output power. Figure 15 shows that for a 10% area loss of the element, the curved element 210a exhibits an 8-10% reduction in maximum thermally-induced stress, and the chamfered element 310a exhibits a 3-4% reduction in maximum thermally-induced stress. In other words, substantially more material must be removed from the chamfered element 310a to achieve the same reduction in thermally-induced stresses found in the curved element 210a. Such considerations are important when considering the effect of fill factor on the overall power output of a thermoelectric module comprising an array of elements 210a or 310a, and the balance between reducing stresses and maximising power output.

Figure 16 shows the reduction in maximum raw stresses in the top surface 20 of element 210a as a function of the area loss at the corners (A₀-A₁)/A₀ relative to square element 110a. This is shown for a number of different element sizes, module sizes and different elements within the same module. While the numerical values change with these factors, in all cases, the curving of element 210a reduces the maximum stress.

By replacing the sharp corners and/or edges of a conventional square thermoelectric element 110a (or 110b) with additional non-coplanar joining faces, the thermally-induced stresses that are concentrated at the sharp corners are reduced.

Both elements 210a and 310a exhibit a significant reduction in the maximum thermally-induced stress at the top surface (20, 30) of the element 210a, 310a compared to square element 110a. This is the interface between the thermoelectric element and the solder or braze, where the element is contacted, in use, with a metallic contact 120. As a result, elements 210a and 310a may be able to withstand a greater thermal gradient, a greater number of thermal cycles, and a greater frequency of thermal cycling without exceeding the yield stress of the element.

Thus, the invention may provide a thermoelectric element with improved lifetime and reliability over the widely used cuboid-type elements. Advantageously, for elements of like-for-like length, width and height, this improvement can be achieved by removing only a relatively small volume of thermoelectric material, thereby maintaining a high fill factor and not sacrificing significant thermoelectric power output.

Similarly, thermoelectric modules and thermoelectric devices according to the invention may also exhibit improved in-service lifetimes and reliability. Thus, such thermoelectric modules and thermoelectric devices may for example be suitable for use in automotive applications.

The precise geometry of elements 210a and 310a is a design choice for a given thermoelectric module, thermoelectric device, thermoelectric material and method of manufacture.

In embodiments, a thermoelectric element according to the invention may comprise one or more planar "chamfered" joining faces and/or one or more curved joining faces.

Thermoelectric elements according to the invention may comprise, or consist essentially of, any suitable thermoelectric material. The choice of thermoelectric material for the elements may be dependent on the range of operating temperatures for a given application. Suitable thermoelectric materials may include, but are not limited to: bismuth telluride; bismuth selenide; antimony telluride; lead telluride; lead selenide; magnesium silicide; magnesium stannide; higher manganese silicide; skutterudite materials; Half Heusler alloys; silicon-germanium, and combinations of the above. Suitable thermoelectric materials may also include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

Typically, thermoelectric elements according to the invention may have a height of at least 0.3 mm and/or up to 5 mm. For example, the height may be up to or at least 0.3 mm, the height may be up to or at least 0.5 mm, up to or at least 1 mm, up to or at least 1.5 mm, up to or at least 2 mm, up to or at least 2.5 mm, up to or at least 3 mm, up to or at least 4 mm or up to or at least 5 mm. The largest lateral dimension of the elements may for example be from at least 0.3 mm and/or up to 3 mm. For example, the largest lateral dimension may be up to or at least 0.3 mm, up to or at least 0.5 mm, up to or at least 1 mm, up to or at least 1.5 mm, up to or at least 2 mm, up to or at least 2.5 mm, up to or at least 3 mm, up to or at least 4 mm or up to or at least 5 mm. For instance, the aspect ratio (height/width) of the elements may be at least 0.25 and/or up to 4. For example, the aspect ratio may be up to or at least 0.25, 0.5, 0.7, 1, 1.2, 1.5, 1.7, 1.9, 2, 2.5, 3, 3.5 or 4.

Thermoelectric elements according to the invention may be manufactured by electrodeposition. Other additive or near-net-shape manufacturing techniques may also be employed. For example the thermoelectric elements may be manufactured by printing a thermoelectric paste or ink. The thermoelectric elements may be consolidated directly into their required shape by for example hot pressing, hot isostatic pressing or Spark Plasma Sintering. Alternatively, for example, thermoelectric elements according to the invention may be manufactured by milling, grinding or machining cuboidal thermoelectric elements into the required shape.

Thermoelectric elements according to the invention, e.g. thermoelectric elements 210a, 210b, 310a, 310b, can be used in a thermoelectric module within a thermoelectric device, such as a thermoelectric generator or a thermoelectric cooler.

A heat recovery system utilising a thermoelectric device comprising one or more thermoelectric elements according to the invention may be arranged to recover heat, in use, from an exhaust or heat exchanger (radiator) of a vehicle such as a car, a lorry or a bus. Heat recovery systems utilising a thermoelectric device comprising one or more thermoelectric elements according to the invention may also be used in non-automotive applications, for example, marine applications, non-terrestrial applications (e.g. satellites and spacecraft), oil and gas, industrial waste heat recovery and remote sensing.

Although the appended claims are directed to particular combinations of features, it should be understood that the scope of the disclosure of the present invention also includes any novel feature or any novel combination of features disclosed herein, either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, and any reference signs in the claims shall not be construed as limiting the scope of the claims.

## Claims

1. A thermoelectric element comprising:
a body comprising, or consisting essentially of, a thermoelectric material, the body having:
a first heat transfer face and a second heat transfer face, wherein the first heat transfer face and the second heat transfer faces are opposing planar faces;
two or more principal lateral faces, each principal lateral face extending between the first heat transfer face and the second heat transfer face; and
at least one joining lateral face, the or each joining lateral face being bounded by an edge of each of a pair of principal lateral faces and an edge of at least one of the first and second heat transfer faces;
wherein the or each joining lateral face is not co-planar with either of said pair of principal lateral faces.

2. The thermoelectric element of claim 1, wherein the surface area of the or each, joining lateral face is smaller than the surface area of at least one of, or optionally both of, the adjoining principal lateral faces.

3. The thermoelectric element of claim 1 or claim 2, wherein the or each joining face is bounded by both the first and second heat transfer faces.

4. The thermoelectric element of claims 1, 2 or 3, wherein at least one of the or each joining lateral face is a convexly curved joining face.

5. The thermoelectric element of claim 4, wherein the or each convexly curved joining face has a uniform radius of curvature or a non-uniform radius of curvature.

6. The thermoelectric element of any one of claims 1, 2 or 3, wherein at least one of the or each joining lateral face is a planar joining face.

7. The thermoelectric element of any one of the preceding claims, wherein the two or more principal lateral faces are substantially perpendicular to the first and second heat transfer faces.

8. The thermoelectric element of any one of the preceding claims, wherein the area lost on the first heat transfer face and/or the second heat transfer face due to the introduction of the joining lateral face(s) is at least 1% and/or up to 20%.

9. The thermoelectric element of any one of the preceding claims comprising three, four, five, six, seven or eight principal lateral faces.

10. The thermoelectric element of any one of the preceding claims, wherein the number of joining lateral faces is up to twice the number of principal lateral faces.

11. The thermoelectric element of any one of the preceding claims, wherein the thermoelectric material comprises or consists essentially of one or more of: bismuth telluride; bismuth selenide; antimony telluride; lead telluride; lead selenide; magnesium silicide; magnesium stannide; higher manganese silicide; skutterudite materials; Half Heusler alloys; and silicon-germanium.

12. A thermoelectric module comprising one or more thermoelectric elements according to any one of claims 1 to 11.

13. A thermoelectric device comprising the thermoelectric module of claim 12.

14. A thermoelectric device according to claim 13, wherein the thermoelectric device is thermoelectric generator or a thermoelectric cooler.

15. Use of a thermoelectric module according to claim 12 or a thermoelectric device according to claim 13 or claim 14 to generate electrical power or to provide cooling.
